Europäisches Patentamt

European Patent Office

Office européen des brevets

(19)

(11) Publication number: **0 061 863**
**B1**

(12) **EUROPEAN PATENT SPECIFICATION**

(45) Date of publication of patent specification: 17.07.85

(21) Application number: 82301340.4

(22) Date of filing: 16.03.82

(51) Int. Cl.⁴: **H 01 L 21/60,** H 01 L 21/48, H 01 L 23/48

(54) **Method of connecting metal leads with electrodes of semiconductor device and metal lead.**

(30) Priority: 16.03.81 JP 37499/81

(43) Date of publication of application:
06.10.82 Bulletin 82/40

(45) Publication of the grant of the patent:
17.07.85 Bulletin 85/29

(84) Designated Contracting States:
DE FR GB

(56) References cited:
EP-A-0 039 160
US-A-3 838 984

SOLID STATE TECHNOLOGY, vol. 23, no. 3,
March 1980, pages 77-83, Washington
(USA);R.F.UNGER et al.: "BTAB's future—An
optimistic prognosis"

(73) Proprietor: Matsushita Electric Industrial Co.,
Ltd.
1006, Oaza Kadoma
Kadoma-shi Osaka-fu, 571 (JP)

(72) Inventor: Hatada, Kenzo
4-8-3, Nanseidai
Katano-shi Osaka-fu (JP)
Inventor: Kitahiro, Isamu
2A64-106, Otokoyamakoro
Yawata-shi Kyoto-fu (JP)

(74) Representative: Crawford, Andrew Birkby et al
A.A. THORNTON & CO. Northumberland House
303-306 High Holborn
London WC1V 7LE (GB)

EP 0 061 863 B1

## Description

This invention relates to a method of connecting metal leads to the electrodes of a semiconductor device, and more particularly relates to such method in which a plurality of leads are bonded at the same time to the semiconductor device and a metal lead therefor.

With the recent progress in miniaturisation of electronic home-appliances and industrial equipment, there has been a need to make small and thin packages of semiconductor devices such as IC, LSI, etc. A silicon wafer on which the semiconductor devices are formed by means of diffusion and making electrodes, is cut into a plurality of chips each forming the basis of a semiconductor device. Each chip is then mounted in a package in order that aluminium electrodes provided at peripheral portions of the chip may be connected to external terminals by leads for ease of handling and to protect the chip from mechanical damage.

Among the hitherto known methods of packaging, the tape carrier method has been an excellent one. According to that method, the semiconductor device is provided with a metal multilayer called barrier metal on each electrode terminal, which metal multilayer is provided with a metal bump by electroplating. A plurality of metal leads supported on a polyimide tape are bonded at the same time to the metal bumps (called lead gang bonding). This method can give high reliability of bonding, a small-size, thin packaging and easy operation in manufacturing.

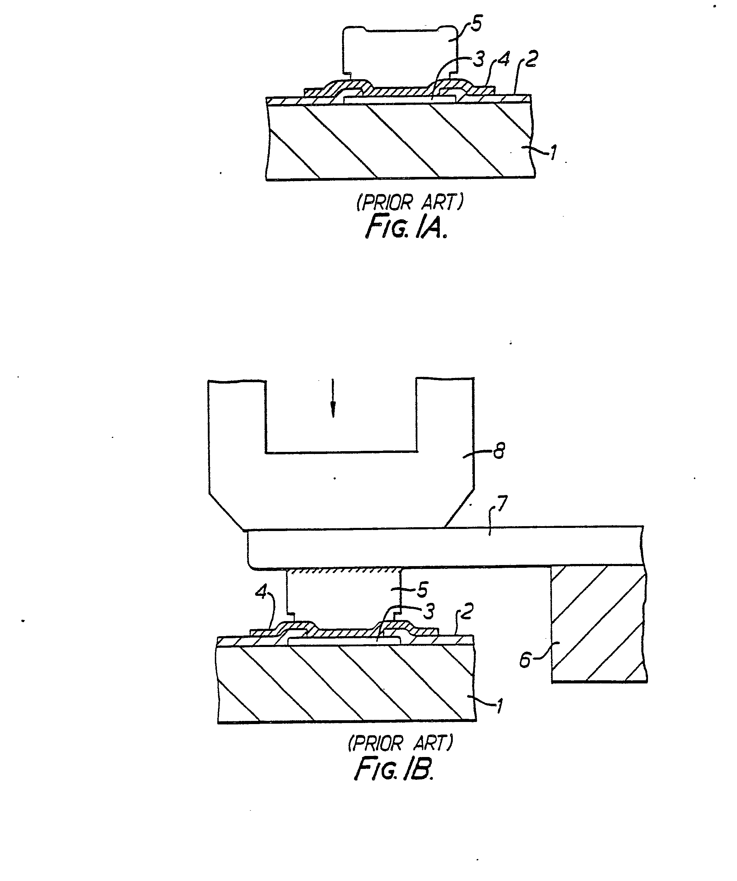

It has, however, shortcomings as will be described in relation to Figures 1A and 1B.

The metal bump in the tape carrier method has a structure as shown in Figure 1A. In this Figure, a semiconductor substrate 1 is provided with a semiconductor device thereon. The substrate 1 is covered with a layer 2 for protecting the semiconductor device. The layer 2 has an opening so as to expose an electrode terminal 3 of the semiconductor device. On that electrode terminal 3 is deposited a barrier metal layer 4 which is composed of a multilayer of Cr—Cu, Ti—Pa, Ni—Cu, etc. and formed by continuous deposition in high vacuum. In such a metal layer, Cr, Ti and Ni improve the strength of bonding to the electrode terminal 3. On the barrier metal layer 4 is formed a metal bump 5. It is formed by electroplating using the barrier metal layer 4 as a cathode and being performed through a photoresist pattern.

Metal leads are connected to the metal bumps as shown in Figure 1B. Metal bumps 5 in Figure 1B are disposed in the direction perpendicular to the sheet. A polyimide tape 6 with metal leads 7 formed thereon is disposed in the same direction as that of the metal bumps 5. Each metal lead 7 is laid upon a respective metal bump 5 and they are pressed together and heated by a tool 8 so that they are bonded. If the metal bump 5 is coated with a plated Au layer and the metal lead 7 with a plated Sn layer, the heating causes Au—Sn eutectic alloy to be made, which gives a high bonding strength.

Such method includes problems as follows:

(a) Since the barrier metal is a multilayer, it is necessary to consider the bonding strength or the barrier resistance between metal layers. If the bonding strength is low, a force applied to the metal lead easily causes peeling off between the metal layers or between the barrier metal and the bump. The large barrier resistance greatly affects the electric properties of the semiconductor device.

(b) The process for making the metal bumps needs techniques such as the deposition of the metal layer, plating, etching of the metal layer and photo-etching, resulting in high manufacturing cost and low yield. Further, such processes necessitate high technology and expensive equipment.

(c) Dangerous and injurious chemicals are used in the process of etching barrier metal. This makes it necessary to consider environmental protection.

(d) There is the possibility that during the bonding of the lead to the bump, produced eutectic may fall on the layer 2 and cause it to crack due to the high temperature, thus reducing its effectiveness and lowering the reliability of the device.

US—A—3838984 discloses a method of connecting metal leads to the electrodes of a semiconductor device in which there is provided a metal lead with a metal bump formed on the end by plating the bump directly to the lead. This bump is then used to connect the lead to the electrode through heating of the bump to cause bonding.

An article in SOLID STATE TECHNOLOGY, Vol. 23, No. 3, March 1980, pages 77—83 by R.F. UNGER et al., discloses a method in which there is provided a metal lead which has a bump etched on it, for connection to an electrode of a semiconductor device.

EP—A—0039160, an application which was published after the priority date of the claims of the present application, discloses a method of connecting metal leads to the electrodes of a semiconductor device in which a metal lead having a bump on its end is utilized. However, the bump is not formed on the lead by the complex methods of plating or etching directly to the lead. The bump is initially formed on a supporting member, and then bonded to the lead by a process of heating, and subsequently removed from the supporting member. However, the bump disclosed in this document is of uniform cross-sectional area, which means that the same area of bump is attached to the support member on to the lead. This can lead to problems in the removal of the bump from the support member.

According to this invention there is provided a method of connecting a metal lead to an electrode of a semiconductor device comprising the steps of: forming a metal bump made of a metal softer than the metal of said lead on a supporting member, the cross sectional area of said metal bump being smaller at the base than at the top; locating the metal lead supported by a film support so that the lead contacts the bump; bonding the lead to the bump by pressing the lead to the bump and heating it; separating said bump from said support member; locating said said metal lead above a semiconductor device so that the metal bump contacts the terminal of the electrode of said semiconductor device; and bonding the metal bump to the electrode by pressing the metal bump onto the electrode and heating it.

This invention also provides a metal lead comprising: a lead body; and a bump made of a metal softer than a metal of said lead body bonded to said lead body by the formation of alloy between the materials of said lead body and said bump, said bump being smaller in cross sectional area at the free end portion thereof than the portion at which it is bonded to the lead body.

Features and advantages of the present invention will become apparent from the following description of embodiments thereof given by way of example with reference to the accompanying drawings, in which:—

Figures 1A and 1B are sectional views showing a conventional tape carrier method;

Figures 2A to 2E are sectional views showing the steps of connection metal leads with electrodes of a semiconductor device according to this invention; in the said Figures, the bumps are not shown to have different cross sectional areas for the sake of convenience;

Figures 3A and 3B are sectional views showing the steps of forming metal bumps embodying this invention;

Figures 4A and 4B are sectional views showing another embodiment of the steps of forming the metal bumps;

Figures 5A and 5B are sectional views illustrating other structures of the metal bump;

Figures 6A and 6B are sectional views illustrating another configuration in elevation of the bump and the steps of forming it;

Figures 7A to 7C are plan views illustrating configurations in the plane of the bump;

Figures 8A to 8D are photographs in magnifications illustrating the steps embodying this invention in which Figures 8A and 8B show areas where the metal leads and bumps are bonded together and Figures 8C and 8D the state where the leads are connected with the electrodes of the semiconductor device; and

Figures 9A and 9B are photographs showing another embodiment of the invention.

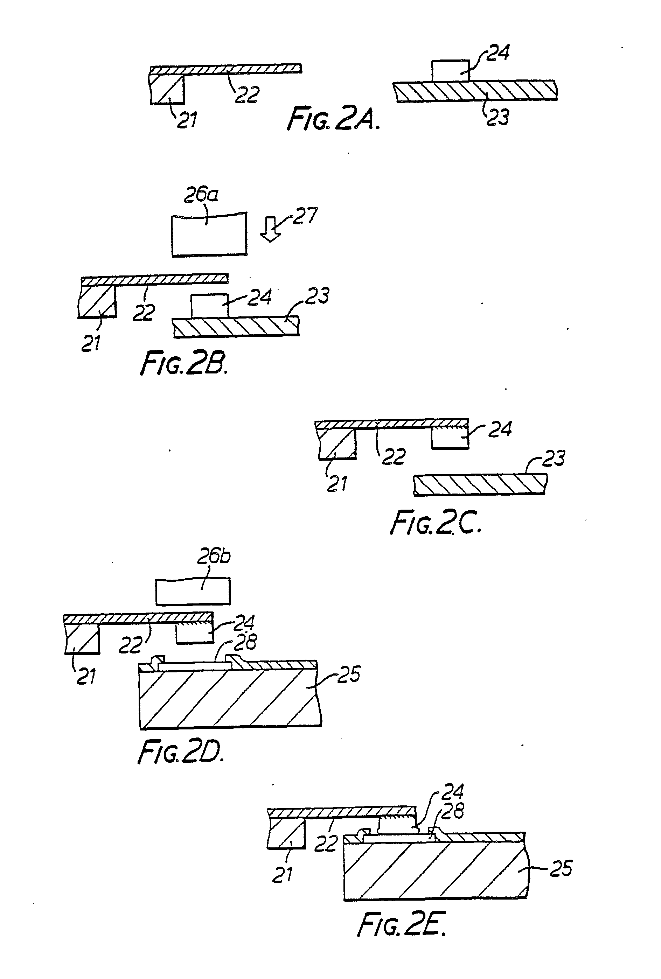

In Figure 2A, a polyimide tape 21 has formed on it a plurality of metal leads 22 which are disposed in a direction perpendicular to the length of the sheet. Each metal lead 22 comprises, for example, Cu leaves of 35 × 10³ nm in thickness with Sn layers of thickness from 0.2 to 1 × 10³ nm deposited by plating and is similar to that in the conventional film carrier method.

A plate 23 supports metal bumps 24 which are formed by electroplating and disposed in the direction similar to that of the leads 22. The intervals between the bumps 24 are made similar to those of the metal leads 22. The metal bumps 24 are made of a metal softer than the metal of the leads 22.

As shown in Figure 2B, the metal leads 22 are laid above the metal bumps 24 and are pressed onto the bumps 24, i.e. in the direction of an arrow 27, by a tool 26a. At the same time the tool 26a heats the metal leads 22 and the metal bump 24. If the metal bumps 24 are made of Au, a eutectic alloy is formed with the Sn of the metal leads 22, whereby strong bonding between the metal lead 22 and the metal bump 24 is obtained. If the bump 24 is made of Au and the lead 22 is made of Cu, the bonding depends on mutual diffusion between the metals of the lead and the bump.

After the tool 26a is removed, as shown in Figure 2C, the metal bumps 24 can be separated from the plate 23. Thus the metal bumps 24 are transferred to the metal leads 22.

Then, as shown in Figure 2D, each of the bumps 24 bonded to the metal leads 22 is positioned above a respective aluminium electrode 28 formed on a semiconductor device. The interval between the electrodes 28 is similar to that of the bumps 24. Then the bumps 24 are pressed to the electrode 28 and heated by a tool 26b and thereby the Au of the metal bumps 24 and aluminium of the electrodes 28 make an alloy at the contacting portion. Since the bump 24 is softer than the lead 22, the pressure is effectively imparted into the bump 24 and the bump is deformed so as to be spread. It gives an advantageous condition for the bonding.

Thus, as shown in Figure 2E, a strong bond between the bumps 24 and the electrodes 28 is achieved.

As mentioned above, the metal bumps 24 prepared on the supporting member are connected to the metal leads 22 which are prepared similarly to those in the conventional film carrier method. That is the bumps are transferred from the support member to the leads. Transferred bumps are easily and strongly bonded, due to the deformation of the bumps, to the electrodes disposed on the semiconductor device.

Although in the above-mentioned example the connection of the metal lead to the metal bump is made by Au—Sn alloy and the metal bump to the electrode by Au—Al alloy, other combinations may be selected according to the materials used for the bump and the electrode. For example, if the electrode is composed of Au, it may be preferable to use Sn for the bump and Au for the surface of the metal lead.

At the transfer of the bump from the support to the lead, the bonding may be made by an adhesive which is thermally removable. In such a case, the adhesive will be removed at the time of bonding the bump to the electrode. Thus the lead is directly bonded to the bump by heating at that time.

The effects achieved by the use of the method according to the invention are as follows:

(1) Since only the metal bump is put between the lead and the electrode, there is no peeling off or generation of barrier resistance as in the conventional film carrier method.

Further since the bonding of all the portions is made by making alloy, the bonding strength is large and the barrier resistance is reduced to a remarkably small value.

(2) In comparison with the conventional film carrier method, the steps for forming the barrier metal such as the deposition step, the photolithography step and the etching step are eliminated. Therefore the manufacturing process is simplified and made less costly.

(3) The formation of the metal bump can be performed by plating on the condition that it is only temporarily bonded to a proper support, regardless of the bonding strength. The bonding strength is rather small because the bump is after transferred to the lead. Therefore the bump can quite easily be formed.

Another process to be performed is the pressing and heating, and only a bonding tool is needed for it.

Thus the method according to this invention includes only easy techniques and requires only cheap equipment, which are practically advantageous features.

In the method according to this invention, the transfer of the metal bumps to the metal leads is an important point to be considered. Examples of the formation of the metal bumps are described hereinafter.

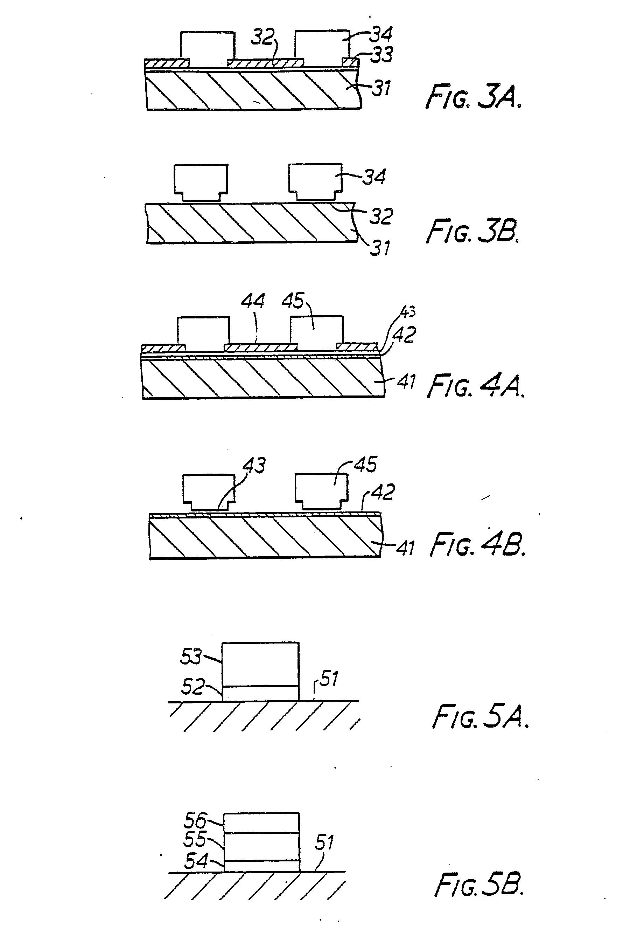

In Figure 3A, 31 denotes a support of an insulating substrate or metal substrate which may be polyimide, ceramics, glass, copper or aluminium. The configuration thereof may be of a disc or tape. A metal layer 32 of a material resembling that of the metal bumps is deposited on the support 31. For example, the support 31 is a polyimide tape and the metal layer 32 is an Au film of 50 to 300 nm in thickness deposited continuously.

Then a photoresist is coated on the metal layer 32 and formed to a pattern 33 similar to the pattern of electrodes on a semiconductor device with which metal leads are to be connected. Metal bumps 34 of Au are formed to a thickness of 10 to $30 \times 10^3$ nm by electroplating, with the photoresist pattern 33 being used as a mask.

After removing the photoresist pattern 33, the metal layer 32 around the metal bumps 34 is removed, as shown in Figure 3B.

Metal bumps 34 thus formed are transferred from the support 31 by heating and elastic deformation of the support 31, because the bonding strength between the polyimide of the support 31 and the deposited metal layer 32 is small. Since the support 31 is subjected to a temperature of about 500°C and pressure, it is required to have a heat resistance and be somewhat rigid.

Figures 4A and 4B show another structure and production method of metal bumps. As shown in Figure 4A, a support 41 is provided with a resin layer 42 and further a metal layer 43 is deposited on the resin layer 42. A photoresist pattern 44 of required configuration is formed on the metal layer 43. Then metal bumps 45 are deposited by, for example, electroplating. Finally the photoresist pattern 44 and the metal layer 43 except the portion beneath the bumps 45 are removed, as shown in Figure 4B.

In this example the support 41 may be of the same material as that in the example in Figure 3. The resin layer 42 is made using as a coating a resin extinguishable mostly due to heating, a photoresist, a polyimide, a silicone or an epoxy, the layer being of a thickness of 10 to 2000 nm. The resin layer 42 is not required to be strongly bonded to the support 41 or the metal layer 43 since it has to be easily separable from the support 41 at the time of transferring the bump 45 while leaving scarcely any residue on the bottom surface of the bumps 45. The metal layer 43 is made of Au, Ag, Ni, Cu, etc. and is deposited to a thickness of about 50 to 1000 nm. After the transfer, it may be left on either the support 41 or the bumps 45. In order to leave the metal layer 43 on the support 41, the metal layer 43 is provided with a material for decreasing the bonding force to the support 41. For example a thin oxide layer having a small electric conductivity may be formed on the surface.

The metal bumps may be multilayer, as shown in Figures 5A and 5B. Figure 5A shows a two-layer bump formed on a support 51, and comprising an Au layer 52 and a layer 53 of Cu, Ni, Ag or Al. In Figure 5B, there are three layers, namely two layers 54 and 56 of Au and a layer 55 of Cu, Ni, Ag or Al.

Such a multilayer structure is employed when the bump is made of a material which hardly makes alloy with the material composing the electrode or the lead. Also the multilayer structure is employed to manufacture the bump at low material-cost by using Au only for limited necessary portions and another cheaper metal for the other portions. Namely only the principal portions of the bump, i.e. the portions to be in contact with the metal lead or electrode, are made of Au and the other portion is made of a cheaper metal.

As for the elevational configuration of the bump, the under part thereof which is to be contacted to the electrode of a semiconductor device is preferably spherical or tapered so that on initial pressing and heating during the transfer step, the pressure is imposed uniformly on the whole portion of the bump, and a metal oxide layer produced naturally on the surface of the electrode of a semiconductor device is removed owing to the pressing by the bump.

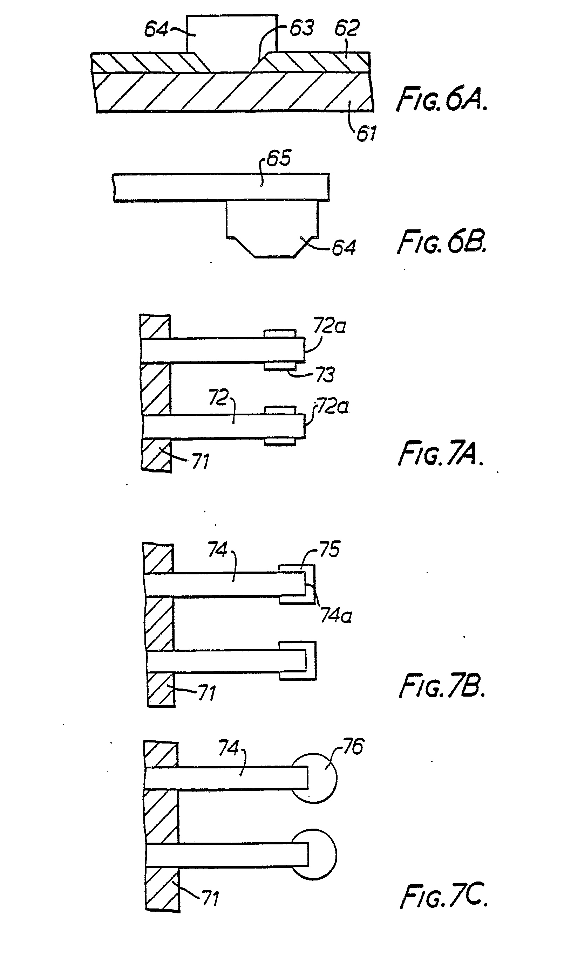

Figures 6A and 6B show an example of a bump having a taper. Referring to Figure 6A, a resin pattern 62 having relatively large thickness is formed on a support 61. The pattern 62 has tapered edges 63 at the area where a bump 64 is to be formed. The bump 64 is formed by plating using the pattern 62 as a mask, so that the bottom end portion of the bump 64 is tapered as shown in Figure 6B where reference numeral 65 denotes a metal lead. The tapered edge 63 can be made by using a mask pattern having a variation of optical density when forming the resin pattern 62, or by changing the exposure time and controlling the development with utilization of underexposure and overexposure.

Examples of the relative positioning of the lead and the bump are described hereinafter.

Figure 7A shows an example in which metal leads 72 disposed on a polyimide film 71 are bonded to metal bumps 73 in the manner that top ends 72a of the leads 72 project beyond the metal bumps 73.

Figure 7B shows an example in which top ends 74a of metal leads 74 are positioned within the area of metal bumps 75. In this example, the pressure applied to the leads 74 is imparted to a direction toward the outside of both edges and the end of the lead 74, though in the example of Figure 7A the pressure is imparted to directions toward the outside of only both edges of the lead 72. Therefore the bonding strength between the lead and bump is easily made large in the example of Figure 7B.

As shown in Figure 7C, a plane configuration of a bump 76 may be a disk.

A more specific example according to the invention is described hereinafter, referring to Figures 2A to 2B.

In this example the semiconductor device 25 is a diode array having a chip size of 1.2 mm × 3.4 mm and including thirty-two diodes. The device has sixty-four aluminium electrodes 28, each of thickness $1.0 \times 10^3$ nm and each providing a terminal, i.e. a region for connection, of $50 \times 10^3$ nm × $100 \times 10^3$ nm in area. The electrodes 28 are disposed on a $100 \times 10^3$ nm pitch.

The metal leads 22 are composed of copper leaves of $35 \times 10^3$ nm in width and disposed in $100 \times 10^3$ nm pitch. The leads 22 are provided with an Sn layer of $0.4 \times 10^3$ nm thick by electrolytic plating.

The support 23 comprises an Si substrate and an Au layer of 50 to 100 nm thick was deposited thereon. On the Au layer metal bumps 24 of Au with a thickness of $20 \times 10^3$ nm are provided by plating.

The leads 22 were laid on the bumps 24 on the support and they were pressed and heated by the bonding tool 27a for 0.75 seconds at a temperature of 500°C and a pressure of 14100 Pa (20 psi). Thus the bumps were bonded to the leads by Au—Sn eutectic alloy and separated from the support.

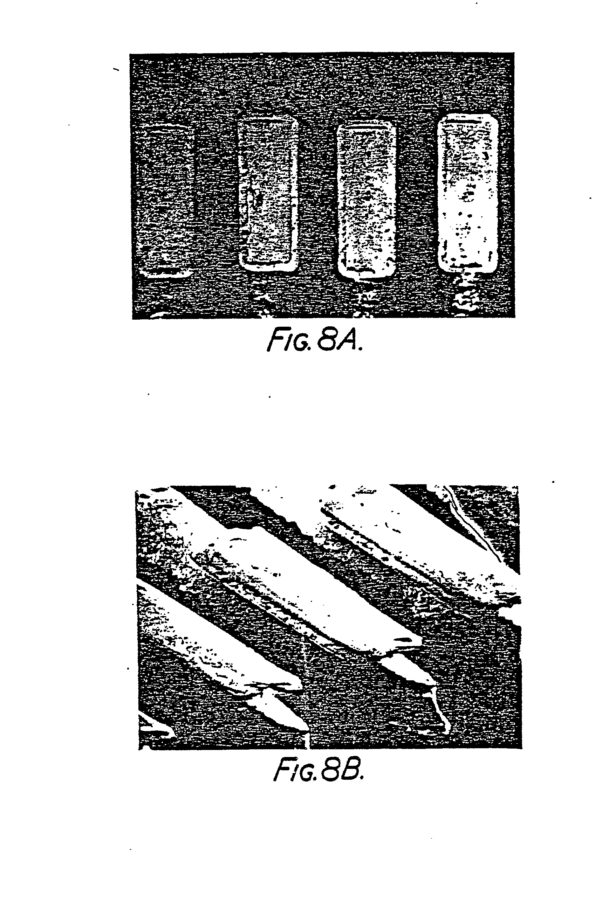

Figure 8A is a photograph of a magnified image showing a plan view of an area where the bumps 24 are bonded to the leads 22. SEM analysis of the same is shown perspectively in Figure 8B.

The bumps 24 bonded to the leads 22 were then laid on the electrodes 28, and pressed and heated by the bonding tool as mentioned above for 1.5 seconds at a temperature of 500°C with the pressure of 28200 Pa (40 psi).

Figure 8C is a photograph of a magnified image showing a plan view of an area where the leads 22 are connected to the electrodes 28, with the bumps 24 being interposed therebetween. SEM analysis of the same is perspectively shown in Figure 8D.

The thus obtained connection was tested for bonding strength. In the case of using a metal lead of 40 to $45 \times 10^3$ nm in width, the bonding portion withstood a force above 15 to 20 g, though the lead was broken.

Another specific example is described hereinafter.

This example is of the case of a semiconductor device having a chip size of 3.4 mm × 3.9 mm and sixty-two electrode terminals of a size of $100 \times 10^3$ nm × $100 \times 10^3$ nm. Metal leads were made of the same material as that of the aforementioned example and were disposed on a $200 \times 10^3$ nm pitch. Metal bumps were made of Au and manufactured by the method shown in Figure 4; the size thereof was $60 \times 10^3$ nm × $60 \times 10^3$ nm in area and $15 \times 10^3$ nm in height.

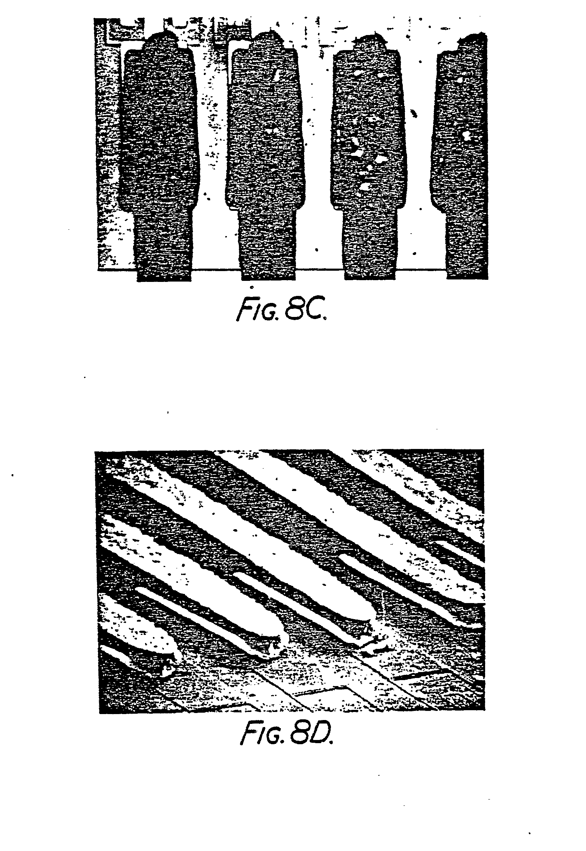

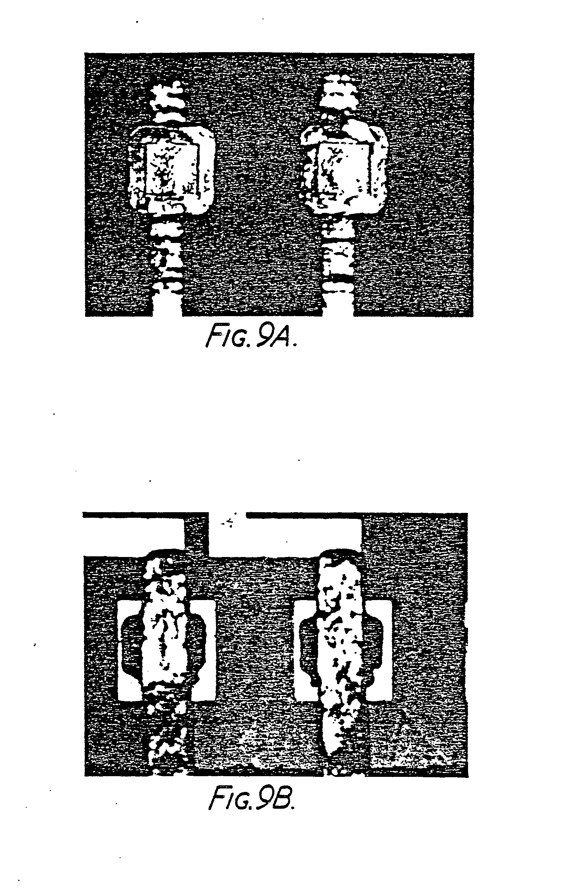

The bumps were transferred to the leads by heating for 0.5 seconds at 500°C, with a pressure of 17625 Pa (25 psi). The bonded state is shown in Figure 9A in plan view by a photograph of a magnified image.

The bonding of the bumps to the semiconductor device was carried out by heating at 475°C for 1.5 seconds, with a pressure of 28200 Pa (40 psi). The bonded area is planely shown in Figure 9B by a photograph of a magnified image.

Thus the method according to this invention can be easily and effectively used irrespectively of chip size of a semiconductor device, size of electrode, a pitch of disposition of the electrodes or number of leads.

**Claims**

1. A method of connecting a metal lead to an electrode of a semiconductor device comprising the steps of:

forming a metal bump (24) (34) made of a metal softer than the metal of said lead on a supporting member (23) (31), the cross sectional area of said metal bump (24) (34) being smaller at the base than at the top;

locating the metal lead (22) supported by a film support (21) so that the lead (22) contacts the bump (24);

bonding the lead (22) to the bump (24) by pressing the lead (22) to the bump (24) and heating it;

separating said bump (24) from said support member (23);

locating said metal lead above a semiconductor device so that the metal bump (24) contacts a terminal of the electrode (28) of said semiconductor device; and

bonding the metal bump (24) to the electrode (28) by pressing the metal bump (24) onto the electrode (28) and heating it.

2. A method as claimed in claim 1, in which said metal bump (34) on said supporting member (31) has a step near the base where the cross sectional area of the bump varies.

3. A method as claimed in claim 1, in which said metal bump (64) on said supporting member (61) is tapered so as to become smaller in sectional area at the base.

4. A method as claimed in claim 1, in which said bump (73) is wider than said metal lead (72).

5. A method as claimed in claim 1, in which:

said lead (22) is bonded to the bump (24) by a thermally removable adhesive; and

said heating in said step of bonding of said metal bump (24) to said electrode (28) is performed in the manner that said adhesive is extinguished and said lead is directly bonded to the bump.

6. A method as claimed in claim 1, in which said supporting member for supporting said metal bump is a plate of a polyimide, ceramics, glass, copper or aluminium.

7. A method as claimed in claim 1, in which said metal bump is formed by plating.

8. A method as claimed in claim 7, in which said metal bump is formed in the manner that:

said supporting member (23) is provided with a metal layer;

a metal composing said bump is selectively plated on said metal layer so as to form the bump; and then the metal layer except the areas under the bump is removed.

9. A method as claimed in claim 8, in which a resin layer (62) is disposed on said support member (61) prior to said provision of the metal layer.

10. A method as claimed in claim 1, in which said metal bump has a multilayer structure and the outermost layers thereof are composed of materials which are easily bonded by heating to materials of the portion to be connected with.

11. A metal lead comprising:

a lead body (65); and

a bump (64) made of a metal softer than a metal of said lead body bonded to said lead body (65) by the formation of alloy between the materials of said lead body (65) and said bump (64), said bump being smaller in cross sectional area at the free end portion thereof than the portion at which it is bonded to the lead body (65).

12. A metal lead as claimed in claim 11, in which said metal bump (34) has a step at its end portion so that the free end portion is smaller in cross sectional area than the portion at which it is bonded to the lead body.

13. A lead as claimed in claim 11, in which said bump (64) is tapered at the free end so as to become smaller in cross sectional area to the end.

## Patentansprüche

1. Verfahren zur Verbindung eines Metalleiters mit der Elektrode einer Halbleitereinrichtung, welches die folgenden Schritte umfaßt: die Ausbildung einer metallischen Erhebung (24, 34) aus einem Metall, welches weicher als das Metall des Leiters auf einem Trägerelement (23, 31) ist, wobei die Querschnittsfläche der metallischen Erhebung (24, 34) an der Basis kleiner als an der Spitze ist;

die Positionierung des Metalleiters (22), der von einem Schichtträger (21) gehalten wird, derart, daß der Leiter (22) die Erhebung (24) berührt;

das Verbinden des Leiters (22) mit der Erhebung (24) dadurch, daß der Leiter (22) gegen die Erhebung (24) gedrückt und erwärmt wird;

das Ablösen der Erhebung (24) von dem Trägerelement (23);

die Positionierung des Metalleiters über der Halbleitervorrichtung derart, daß die metallische Erhebung (24) einen Anschluß der Elektrode (28) der Halbleitervorrichtung berührt; und

die Verbindung der metallischen Erhebung (24) mit der Elektrode (28) dadurch, daß die metallische Erhebung (24) auf die Elektrode (28) gedrückt und erwärmt wird.

2. Verfahren nach Anspruch 1, wobei die metallische Erhebung (34) auf dem Trägerelement (31) in der Nähe der Basis eine Abstufung hat, an der sich die Querschnittsfläche der Erhebung verändert.

3. Verfahren nach Anspruch 1, bei dem die metallische Erhebung (64) auf dem Trägerelement (61) so geformt ist, daß die Schnittfläche zur Basis hin kleiner wird.

4. Verfahren nach Anspruch 1, bei dem die Erhebung (72) breiter als der Metalleiter (72) ist.

5. Verfahren nach Anspruch 1, bei dem der Leiter (22) mit der Erhebung (24) mittels eines thermisch entfernbaren Klebstoffes verbunden wird; und

bei dem die Erwärmung in dem Schritt, in dem die metallische Erhebung (24) mit der Elektrode (28) verbunden wird, so durchgeführt wird, daß der Klebstoff entfernt und der Leiter direkt mit der Erhebung verbunden wird.

6. Verfahren nach Anspruch 1, bei dem das Trägerelement, welches die metallische Erhebung trägt, eine Platte aus Polyimid, Keramik, Glas, Kupfer oder Aluminium ist.

7. Verfahren nach Anspruch 1, wobei die metallische Erhebung durch Galvanisierung gebildet wird.

8. Verfahren nach Anspruch 7, wobei die metallische Erhebung erzeugt wird, indem das Trägerelement (23) mit einer Metallschicht versehen wird und daß ein Metall, welches die Erhebung bildet, auf die Metallschicht selektiv aufgalvanisiert wird, um die Erhebung zu bilden und daß dann die Metallschicht mit Ausnahme der Bereiche unterhalb der Erhebung entfernt wird.

9. Verfahren nach Anspruch 8, bei dem eine Harzschicht (62) auf das Trägerelement (61) aufgebracht wird, bevor die Metallschicht erzeugt wird.

10. Verfahren nach Anspruch 1, bei dem die metallische Erhebung eine Mehrschichtstruktur hat und bei dem die äußere Schicht aus Materialien besteht, die sich bei Erwärmung leicht mit Materialien verbinden, welche sich auf dem Bereich befinden, mit dem die Verbindung hergestellt werden soll.

11. Metalleiter mit einem Leiterkörper (65) und einer Erhebung (64), die aus einem Metall hergestellt ist, welches weicher als das Metall des Leiterkörpers ist und wobei die Erhebung mit dem Leiterkörper (65) durch die Erzeugung einer Legierung zwischen den Materialien des Leiterkörpers (65) und der Erhebung (64) verbunden wird, und wobei die Querschnittsfläche der Erhebung an ihrem freien Endbereich kleiner als in dem Bereich ist, an dem sie mit dem Leiterkörper (65) verbunden ist.

12. Metalleiter nach Anspruch 11, bei dem die metallische Erhebung (34) eine Stufe an ihrem Endbereich hat, so daß die Querschnittsfläche an diesem freien Ende kleiner als an dem Bereich ist, an dem sie mit dem Leiterkörper verbunden ist.

13. Leiter nach Anspruch 11, bei dem die Erhebung (64) zum freien Ende hin spitz zuläuft, so daß die Querschnittsfläche zum freien Ende hin kleiner wird.

## Revendications

1. Procédé pour connecter un conducteur métallique à une électrode d'un dispositif semi-conducteur, comportant les phases de:

former un tampon métallique (24) (34) fait d'un métal plus doux que le métal dudit conducteur sur un élément support (23) (31), la surface de section droite dudit tampon métallique (24) (34) étant plus faible à la base qu'en tête;

placer le conducteur métallique (22) supporté par un film support (21) de façon que le conducteur (22) soit au contact du tampon (24);

lier le conducteur (22) au tampon (24) en appuyant le conducteur (22) contre le tampon (24) et en le chauffant;

séparer ledit tampon (24) d'avec ledit élément support (23);

placer ledit conducteur métallique au-dessus d'un dispositif semi-conducteur de façon que le tampon métallique (24) vienne au contact d'une borne de l'électrode (28) dudit dispositif semi-conducteur; et

lier le tampon métallique (24) à l'électrode (28) en appuyant le tampon métallique (24) contre l'électrode (28) et en le chauffant.

2. Procédé comme revendiqué dans la revendication 1, dans lequel ledit tampon métallique (34) qui se trouve sur ledit élément support (31) présente un gradin près de la base à l'endroit où la surface de section droite du tampon varie.

3. Procédé selon la revendication 1, dans lequel le dit tampon métallique (64) qui se trouve sur ledit élément support (61) est conique de façon à avoir une surface de section droite plus faible à la base.

4. Procédé comme revendiqué dans la revendication 1, dans lequel ledit tampon (73) est plus large que ledit conducteur métallique (72).

5. Procédé comme revendiqué dans la revendication 1, dans lequel:

ledit conducteur (22) est lié au tampon (24) par une colle thermiquement enlevable; et

ledit chauffage dans ladite phase de liaison dudit tampon métallique (24) à ladite électrode (28) s'exécute de façon que ladite colle s'enlève et que ledit conducteur soit directement lié au tampon.

6. Procédé comme revendiqué dans la revendication 1, dans lequel ledit élément support pour supporter ledit tampon métallique est une plaque de polyimide, céramique, verre, cuivre ou aluminium.

7. Procédé comme revendication dans la revendication 1, dans lequel ledit tampon métallique est formé par électroplastie.

8. Procédé comme revendiqué dans la revendication 7, dans lequel ledit tampon métallique est formé de façon que:

ledit élément support (23) comporte une couche métallique;

un métal composant ledit tampon est sélectivement déposé sur ladite couche métallique de façon à former le tampon; puis on enlève la couche métallique à l'exception des zones situées sous le tampon.

9. Procédé comme revendiqué dans la revendication 8, dans lequel une couche résine (62) est disposée sur ledit élément support (61) avant ledit apport de la couche métallique.

10. Procédé comme revendiqué dans la revendication 1, dans lequel ledit tampon métallique a une structure multicouche, ses couches les plus extérieures étant composées de matériaux qui se lient facilement par chauffage aux matériaux de la portion à laquelle ils doivent être connectés.

11. Conducteur métallique comportant:

un corps de conducteur (65); et

un tampon (64) fait d'un métal plus doux qu'un métal dudit corps de conducteur, lié audit corps de conducteur (65) par la formation d'alliage entre les matériaux dudit corps de conducteur (65) et dudit tampon (64), ledit tampon ayant, à sa portion d'extrémité libre, une surface de section droite inférieure à celle de la portion à laquelle il est lié au corps de conducteur (65).

12. Conducteur métallique comme revendiqué dans la revendication 1, dans lequel ledit tampon métallique (34) présente à sa portion d'extrémité un gradin de sorte que la portion d'extrémité libre a une surface de section droite inférieure à celle de la portion à laquelle il est lié au corps du conducteur.

13. Conducteur comme revendiqué dans la revendication 11, dans lequel ledit tampon (64) est conique à l'extrémité libre de façon à avoir une surface de section droite plus faible à l'extrémité.

0 061 863

(PRIOR ART)
FIG. IA.

(PRIOR ART)
FIG. IB.

24

22

21

FIG. 2A.

23

26a

27

22

24

23

21

FIG. 2B.

24

22

23

21

FIG. 2C.

26b

24
28

22

25

21

FIG. 2D.

24
28

22

25

21

FIG. 2E.

FIG. 3A.

FIG. 3B.

FIG. 4A.

FIG. 4B.

FIG. 5A.

FIG. 5B.

*FIG. 6A.*

*FIG. 6B.*

*FIG. 7A.*

*FIG. 7B.*

*FIG. 7C.*

4

FIG. 8A.

FIG. 8B.

*FIG. 8C.*

*FIG. 8D.*

FIG. 9A.

FIG. 9B.